# EUROPEAN PATENT APPLICATION

(11) **EP 4 835 896 A1**
(43) Date of publication of application: **04.11.2026**
(21) Application number: 25214496.9
(22) Date of filing: 10.11.2025
(51) Int. Cl.: G11C 11/16, G11C 11/18, G11C 11/56

(54) **SPINTRONIC DEVICE CAPABLE OF IMPROVING SPIN TORQUE BY COMBINATION OF MAGNETIC DOMAINS, AND ELECTRONIC DEVICES INCLUDING THE SAME**

(30) Priority: 28.04.2025 KR 20250055309; 25.07.2025 KR 20250101409; 16.10.2025 KR 20250149537
(71) Applicant: UIF (University Industry Foundation), Yonsei University, Seoul 03722 (KR)
(72) Inventor: HONG, Jongill, 03722 Seoul (KR); JEONG, Jaegyu, 03722 Seoul (KR)
(74) Representative: Michalski Hüttermann & Partner mbB

(57) **Abstract**

Provided is a spintronic device. The spintronic device includes a magnetic free layer having magnetic domains formed to have a magnetic anisotropy energy gradient and whose magnetization direction is switched by spin torque, and a spin Hall effect layer formed below or above the magnetic free layer and configured to generate a spin current from a charge current by a spin Hall effect and generate the spin torque in the magnetic free layer based on the spin current, wherein the magnetization direction of the magnetic free layer is switched by the spin torque even in an absence of an external magnetic field applied to the spintronic device.

## Description

### CROSS-REFERENCE TO RELATED APPLICATIONS

This application claims priority under 35 U.S.C. § 119 from Korean Patent Application No. 10-2025-0055309, filed on April 28, 2025, No. 10-2025-0101409, filed on July 25, 2025, and No. 10-2025-0149537, filed on October 16, 2025 the disclosure of each of which is hereby incorporated by reference in its entirety.

### BACKGROUND

The present invention relates to electronic devices, and more particularly, to spintronic devices capable of improving spin torque by combination of magnetic domains formed to have a magnetic anisotropy energy gradient, and electronic devices including the same.

A ferromagnetic electronic device is an electronic device that uses a ferromagnetic material. A ferromagnetic material is a material that is subjected to magnetization reversal by an external magnetic field or current and has a property of maintaining its magnetization state after the magnetization reversal. This property makes ferromagnetic electronic devices suitable for data processing and storage.

For example, a ferromagnetic memory is generally related to spintronic technology, and the spintronics is a technology that processes information using the spin and charge of electrons.

A ferromagnetic memory includes a ferromagnetic element that records information using its magnetization state to store data, and a switching element that controls the magnetization state of the ferromagnetic material to read and write data.

A ferromagnetic memory includes a magnetic tunnel junction (MTJ) formed by inserting a thin insulating layer between two ferromagnetic layers.

While a magnetization direction of one of the two ferromagnetic layers, a reference layer (or pinned layer), is fixed, a magnetization direction of the other, a magnetic free layer, can be reversed.

### SUMMARY

An object of the present invention is to provide a spintronic device including magnetic domains formed to have a magnetic anisotropy energy gradient and electronic devices including the same so as to enable switching by spin torque even at a low charge current without an aid of an external magnetic field.

An exemplary embodiment of the present invention is directed to a spintronic device, including a magnetic free layer having magnetic domains formed to have a magnetic anisotropy energy gradient and whose magnetization direction is switched by spin torque, and a spin Hall effect layer formed below or above the magnetic free layer and configured to generate a spin current from a charge current by a spin Hall effect and generate the spin torque in the magnetic free layer based on the spin current, wherein the magnetization direction of the magnetic free layer is switched by the spin torque even in an absence of an external magnetic field applied to the spintronic device.

Another exemplary embodiment of the present invention is directed to a memory device, including a memory cell array including memory cells for storing data, and a memory control circuit connected to the memory cell array and used for reading or writing data from or to the memory cells, in which each of the memory cells includes a magnetic free layer having magnetic domains formed to have a magnetic anisotropy energy gradient and whose magnetization direction is switched by spin torque, and a spin Hall effect layer formed below or above the magnetic free layer and configured to generate a spin current from a charge current by a spin Hall effect and generate the spin torque in the magnetic free layer based on the spin current, wherein the magnetization direction of the magnetic free layer is switched by the spin torque even in an absence of an external magnetic field applied to the memory device.

Still another exemplary embodiment of the present invention is directed to an electronic device, including a memory device and a processor configured to control an operation of the memory device, in which the memory device includes a memory cell array including memory cells for storing data, and a memory control circuit connected to the memory cell array and configured to read or write data from or to the memory cells, each of the memory cells includes a magnetic free layer having magnetic domains formed to have a magnetic anisotropy energy gradient and whose magnetization direction is switched by spin torque, and a spin Hall effect layer formed below or above the magnetic free layer and configured to generate a spin current from a charge current by a spin Hall effect and generate the spin torque in the magnetic free layer based on the spin current, wherein the magnetization direction of the magnetic free layer is switched by the spin torque even in an absence of an external magnetic field applied to the memory device.

The magnetic domains are formed by irradiating the magnetic free layer with one or more types of ions, each type being accelerated at one or more energy levels or combinations thereof.

The total spin torque applied to the magnetic free layer is greater than a total spin torque applied to a magnetic free layer including magnetic domains in which no a magnetic anisotropy energy gradient is formed.

### BRIEF DESCRIPTION OF THE DRAWINGS

To more fully understand the drawings cited in the detailed description of the present invention, a detailed description of each drawing is provided.
FIG. 1 is a schematic diagram of a semiconductor system which includes a ferromagnetic memory device structure having a memory cell including a magnetic layer with a magnetic anisotropy energy gradient induced by magnetic domains, according to an embodiment of the present invention;
FIG. 2 is a plan view of a magnetic free layer included in the ferromagnetic memory device shown in FIG. 1;
FIG. 3 is a schematic diagram of the ferromagnetic memory device shown in FIG. 2, taken in an A-A direction;
FIG. 4 is an enlarged view of a memory cell of the ferromagnetic memory device shown in FIG. 2;
FIG. 5A is an enlarged view of the memory cell shown in FIG. 2 before a magnetic anisotropy energy gradient is formed in the memory cell shown in FIG. 2, and FIG. 5B is a schematic diagram of the memory cell shown in FIG. 5A, taken in a B-B direction;
FIG. 6 is a schematic diagram for describing a method for generating a first magnetic domain by irradiating a first region of a memory cell region shown in FIG. 5A with ions accelerated at a first acceleration voltage through a first mask pattern;
FIG. 7 is a schematic diagram for describing a method for generating a second magnetic domain by irradiating a second region of the memory cell region shown in FIG. 5A with ions accelerated at a second acceleration voltage through a second mask pattern;
FIG. 8 is a schematic diagram for describing a method for generating a third magnetic domain by irradiating a third region of the memory cell region shown in FIG. 5A with ions accelerated at a third acceleration voltage through a third mask pattern;
FIG. 9 is a schematic diagram for describing a method for irradiating a magnetic free layer of a memory cell with ions at 0.2keV or 0.5keV so that the memory cell has uniform magnetic properties;
FIG. 10A is a graph which shows a relationship among a first harmonic voltage measured in a ferromagnetic memory device including a memory cell, an in-plane magnetic field, and magnetization directions when a magnetic free layer of the memory cell is irradiated with ions at 0.2keV as shown in FIG. 9;
FIG. 10B is a graph which shows a relationship among a second harmonic voltage measured in a ferromagnetic memory device including a memory cell, an in-plane magnetic field, and magnetization directions when a magnetic free layer of the memory cell is irradiated with ions at 0.2keV as shown in FIG. 9;
FIG. 11A is a graph which shows a relationship among a first harmonic voltage measured in a ferromagnetic memory device including a memory cell, an in-plane magnetic field, and magnetization directions when a magnetic free layer of the memory cell is irradiated with ions at 0.5keV as shown in FIG. 9;
FIG. 11B is a graph which shows a relationship among a second harmonic voltage measured in a ferromagnetic memory device including a memory cell, an in-plane magnetic field, and magnetization directions when a magnetic free layer of the memory cell is irradiated with ions at 0.5keV as shown in FIG. 9.
FIG. 12A is a graph which shows a relationship among a value obtained by transforming a second harmonic voltage measured in a ferromagnetic memory device including a memory cell having a magnetic free layer with magnetic domains formed thereon according to different acceleration energies into second harmonic resistance, an in-plane magnetic field, and a current, according to an embodiment of the present invention.
FIG. 12B is a graph which shows a relationship among a value obtained by transforming a second harmonic voltage measured in a ferromagnetic memory device including a memory cell, an in-plane magnetic field, and a current when a magnetic free layer of the memory cell is irradiated with ions at 0.2keV as shown in FIG. 9.
FIG. 12C is a graph which shows a relationship among a value obtained by transforming a second harmonic voltage measured in a ferromagnetic memory device including a memory cell, an in-plane magnetic field, and a current when a magnetic free layer of the memory cell is irradiated with ions at 0.5keV as shown in FIG. 9.
FIG. 13A is a graph which shows a relationship among a current density supplied to a ferromagnetic memory device including a memory cell having a magnetic free layer with magnetic domains formed thereon according to different acceleration energies, damping-like torque, and magnetization directions, according to an embodiment of the present invention.
FIG. 13B is a graph which shows a relationship among a current density supplied to a ferromagnetic memory device including a memory cell, damping-like torque, and magnetization directions when a magnetic free layer of the memory cell is irradiated with ions at 0.2keV as shown in FIG. 9.
FIG. 13C is a graph which shows a relationship among a current density supplied to a ferromagnetic memory device including a memory cell, damping-like torque, and magnetization directions when a magnetic free layer of the memory cell is irradiated with ions at 0.5keV as shown in FIG. 9.
FIG. 14A is a graph which shows a relationship between a charge current and spin torque switching in a memory cell having a magnetic free layer with magnetic domains formed thereon according to an embodiment of the present invention when an external magnetic field is present.
FIG. 14B is a graph which shows a relationship between a charge current and spin torque switching in a memory cell having a magnetic free layer with magnetic domains formed thereon according to an embodiment of the present invention when an external magnetic field is not present.
FIG. 15 is a block diagram of a memory device including the ferromagnetic memory device shown in FIG. 1.
FIG. 16 is a block diagram of a memory system including the memory device shown in FIG. 15.

### DETAILED DESCRIPTION OF THE EMBODIMENTS

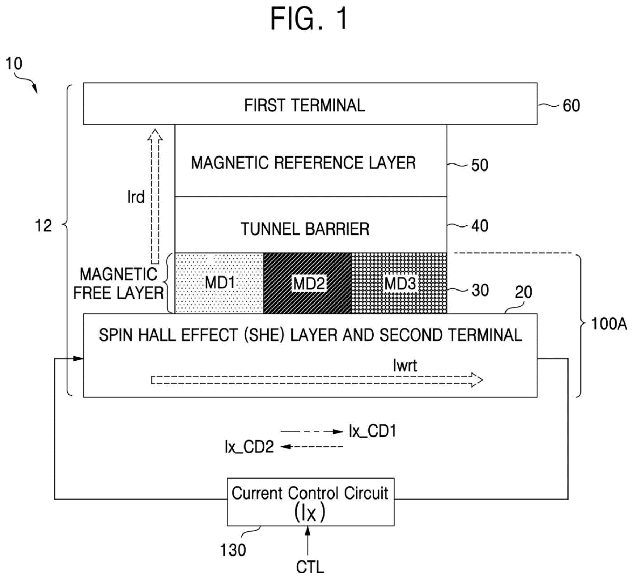

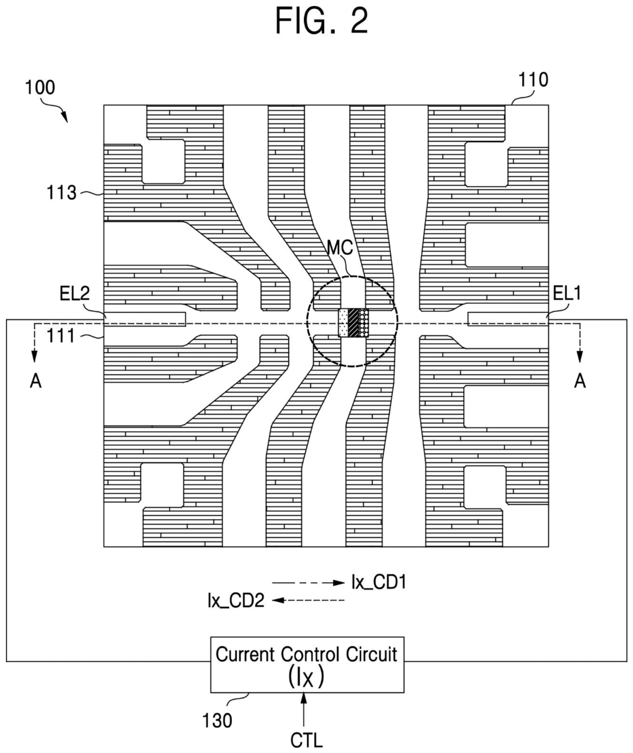

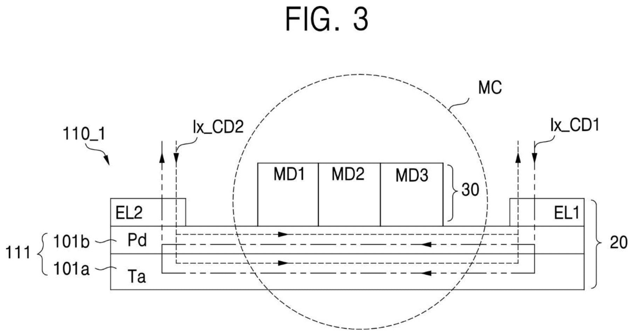

FIG. 1 is a schematic diagram of a semiconductor system including a ferromagnetic memory device structure having a memory cell including a magnetic layer with a magnetic anisotropy energy gradient induced by magnetic domains according to an embodiment of the present invention, FIG. 2 is a plan view of a magnetic free layer included in the ferromagnetic memory device shown in FIG. 1, and FIG. 3 is a schematic diagram of the ferromagnetic memory device shown in FIG. 2, taken in an A-A direction.

The semiconductor system 10 shown in FIG. 1 includes a ferromagnetic memory device 12 and an input current control circuit 130. The ferromagnetic memory device 12 is an example of a spintronic device, and the spintronic device is an electronic device that stores or processes information by simultaneously using spin and charge of electrons. As shown in FIG. 2, a memory cell MC may include the ferromagnetic memory device 12. The ferromagnetic memory device 12 may be used in logic circuit or a magnetoelectric spin-orbit (MESO) logic element.

A drawing number 100A of FIG. 1 includes a composite layer 20 including a spin Hall effect (SHE) layer and a second terminal, and a magnetic free layer 30. For convenience of description, FIG. 2 shows a plan view 100 of the magnetic free layer 30 along with an input current control circuit 130. At this time, a drawing number 110 may represent an upper surface of the magnetic free layer 30. The SHE layer may or may not be a metal layer.

The semiconductor system 10 may refer to a semiconductor device, a semiconductor integrated circuit, a system on chip (SoC), a process-in-memory (PIM), a computing-in-memory (CIM), or a processor.

The ferromagnetic memory device 12 according to an embodiment of the present invention refers to a device capable of storing one bit or two or more bits of data using properties of a ferromagnetic material.

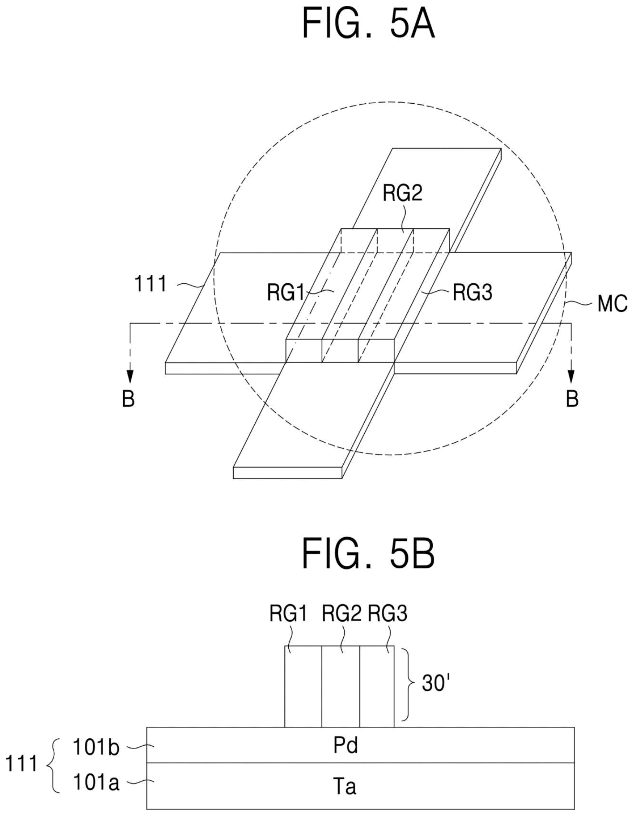

The ferromagnetic memory device 12 may be implemented such that each of arbitrarily divided regions RG1 to RG3, included in a magnetic layer (hereinafter referred to as a 'first magnetic layer 30") of a memory cell MC shown in FIG. 5A, has a magnetic anisotropy energy gradient formed therein. This may be achieved, for example, using a plurality of photolithography processes, through ion irradiation with one or more types of ions, each type being accelerated at one or more energy levels or combinations thereof, for each process. For example, the plasma ion implantation method may be used as the ion irradiation method.

For example, a first magnetic layer 30' may include a magnetic material, which may include at least one of a ferromagnetic material, a paramagnetic material, or an antiferromagnetic material. According to embodiments, the magnetic material included in the first magnetic layer 30' may include, but is not limited to, (i) a paramagnetic material or (ii) both a paramagnetic material and a ferromagnetic material.

Ions accelerated at different acceleration voltages (or acceleration energies) at different time points and/or combinations of different type of ions at different time points are irradiated or implanted into memory cells (MC), such as in each region RG1 to RG3. As a result, magnetic domains MD1, MD2, and MD3 having different magnetic anisotropy energies are formed in the memory cell (MC), thereby forming a magnetic anisotropy energy gradient within the memory cell (MC).

Referring to FIGS. 1 to 3, the ferromagnetic memory device 12 includes a memory cell MC that includes a composite layer 20 and a magnetic free layer 30. The composite layer 20 including electric conductive layer 111 includes current electrodes EL1 and EL2 and receives an input current or voltage thereto.

The ferromagnetic memory device 12 includes the composite layer 20 having the spin Hall effect(SHE) layer and the second terminal, the magnetic free layer 30, a tunnel barrier 40, a magnetic reference layer (or magnetic pinned layer) 50, and a first terminal 60.

The SHE layer may be formed beneath the magnetic free layer 30 and may generate a spin current from a charge current Ix_CD1 or Ix_CD2 using an SHE, and generate spin torque in or to the magnetic free layer 30 based on the spin current. For example, the SHE layer may include a non-magnetic material and may refer to the electric conductive layer 111 shown in FIG. 3. Although the SHE layer 111 (referred to as the electric conductive layer 111) is shown beneath the magnetic free layer 30 in FIG. 1, the SHE layer 111 may be disposed above the magnetic free layer 30 according to an embodiment.

Each of the magnetic domains MD1, MD2, and MD3 formed in the magnetic free layer 30 has a property of being switched or having its magnetization direction reversed by spin torque caused by a charge current or spin current.

Spin torque generated due to or resulting from the SHE layer is a general term for torque that changes (or reverses) a magnetization direction of a magnetic material (e.g., the magnetic free layer 30) using spin (or spin angular momentum) or orbital (or orbital angular momentum). It may include, but is not limited to, at least one of spin-transfer torque (STT), spin-orbit torque (SOT) or orbital torque.

The tunnel barrier 40 is formed between the magnetic free layer 30 and the magnetic reference layer 50, and electrons may tunnel between the magnetic free layer 30 and the magnetic reference layer 50.

The first terminal 60 is electrically connected to the magnetic reference layer 50 and may receive a control voltage that controls a current Ird flowing in a magnetic tunnel junction (MTJ). The MTJ may include the magnetic free layer 30, the tunnel barrier 40, and the magnetic reference layer 50.

The second terminal performs a function of supplying the charge current Ix_CD1 or Ix_CD2 to the SHE layer 111, and includes a first current electrode EL1 and a second current electrode EL2.

Spin torque switching refers to a phenomenon or action that reverses (or switches) the magnetization direction (or spin direction) of the magnetic free layer 30 using spin torque caused by a charge current Iwrt or spin current flowing through the second terminal. The magnetization direction (or spin direction) of the magnetic free layer 30 can be reversed (or switched) by spin torque switching.

The ferromagnetic memory device 12 may be an MTJ memory device, for example, a spin-orbit torque magnetic random access memory (SOT MRAM).

When the ferromagnetic memory device 12 is an SOT MRAM, a write current Iwrt for a write operation may flow through the SHE layer 111, and a read current Ird for a read-out operation may flow from the first terminal 60 to the ground or a source line connected to the composite layer 20 through the MTJ.

The electric conductive layer 111 or SHE layer 111 includes at least one of palladium (Pd), tantalum (Ta), gold (Au), platinum (Pt), copper (Cu), tungsten (W), or aluminum (Al), but is not limited to.

As magnetic domains, also referred to as magnetic patterns MD1, MD2, and MD3 are formed within the magnetic free layer 30, a magnetic anisotropy energy gradient is formed (or induced). However, the magnetic anisotropy energy gradient may generate (or induce) one or more new magnetization states within the magnetic free layer 30.

The magnetic free layer 30 forms a magnetic anisotropy energy gradient by a plurality of magnetic domains MD1, MD2, and MD3 or a plurality of magnetic domains MD1, MD2, and MD3 in different magnetization states.

For example, each of the magnetic domains MD1, MD2, and MD3 formed in a magnetic layer (hereinafter referred to as a "second magnetic layer") included in the magnetic free layer 30 refers to a ferromagnetic material region (or ferromagnetic material).

For example, a drawing number 113 may represent a portion etched in an etching process, and the etched portion may be filled with a material, such as an insulating material.

In magnetic materials, magnetic anisotropy refers to a phenomenon in which a specific magnetization direction is preferred in terms of energy. Energy is minimized when magnetization is aligned in a most stable direction (easy axis) within a material, and is increased when the magnetization is rotated in a different direction away from the most stable direction. A difference in energy that occurs at this time is called magnetic anisotropy energy.

The magnetic anisotropy energy gradient describes how a magnitude of the magnetic anisotropy energy in a magnetic material varies depending on a physical direction of the material.

Referring to a cross-section taken in an A-A direction of FIG. 2, i.e., a cross-sectional view 110_1 of FIG. 3, a memory cell MC may include a tantalum (Ta) layer 101a, a palladium (Pd) layer 101b formed on the tantalum layer 101a, and a second magnetic layer 30 including the magnetic domains MD1, MD2, and MD3 formed on the palladium layer 101b. According to the embodiments, positions of the tantalum layer 101a and the palladium layer 101b may be interchanged.

For example, the palladium layer 101b in the memory cell MC may absorb and store hydrogen (or hydrogen ions) remained in each of the magnetic domains MD1, MD2, and MD3 by hydrogen ion irradiation.

The second magnetic layer 30 may include ferromagnetic material regions MD1, MD2, and MD3 related to a magnetic anisotropy energy gradient. For example, the second magnetic layer 30 may include a magnetic material, and the magnetic material may include at least one of a ferromagnetic material, a paramagnetic material, or an antiferromagnetic material. According to the embodiments, the magnetic material included in the second magnetic layer 30 may include, but is not limited to, (i) a paramagnetic material or (ii) both a paramagnetic material and a ferromagnetic material.

A technical concept of the present invention is to significantly increase spin torque by forming a magnetic anisotropy energy gradient in the magnetic free layer 30, thereby enabling spin torque switching with a very small current even in the absence of an external magnetic field or even without an external magnetic field. Therefore, as an example of a method for forming the magnetic anisotropy energy gradient in the magnetic free layer 30, a method of generating the magnetic domains MD1, MD2, and MD3 through ion irradiation will be described in detail with reference to FIGS. 5 to 8.

A magnitude of spin torque generated in the SHE layer can be expressed as a spin Hall angle, damping-like torque, field-like torque, or the like.

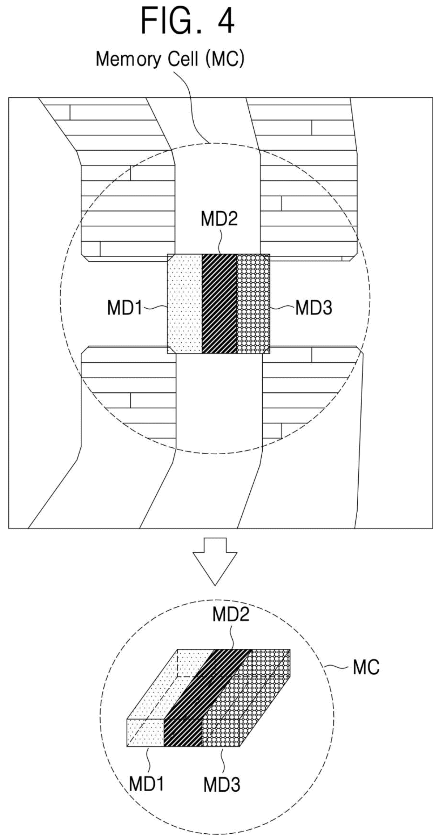

To describe formation of a magnetic anisotropy energy gradient as the magnetic domains MD1, MD2, and MD3 with different magnetic anisotropy energies are formed within the memory cell MC, FIGS. 2 and 4 show the magnetic domains MD1, MD2, and MD3 formed within the ferromagnetic memory device 12 all together in a plan view 100 of the memory cell MC of the ferromagnetic memory device 12.

Referring to FIG. 3, a thickness of the tantalum layer 101a within the memory cell MC may be 4 nm, a thickness of the palladium layer 101b may be 3 nm, and a thickness of the second magnetic layer 103c in which the magnetic domains MD1, MD2, and MD3 are formed may be 0.7 nm, but the present invention is not limited thereto.

The input current control circuit 130 generates an input current (also referred to as an 'input pulse current', Ix) whose characteristics change according to a current control signal CTL and transmits it to a current electrode EL1 or EL2.

Here, the characteristics may include the number of pulses (or the number of times of toggling) included in an input current Ix, a pulse width of the input current Ix, or an amplitude of the input current Ix.

Moreover, the input current control circuit 130 may control a direction of the input current Ix according to the current control signal CTL. As shown in FIGS. 1 to 3, the input current Ix flowing from the first current electrode EL1 to the second current electrode EL2 is referred to as a first-direction input current Ix_CD1, and the input current Ix flowing from the second current electrode EL2 to the first current electrode EL1 is referred to as a second-direction input current Ix_CD2.

Referring to FIG. 3, each of the current electrodes EL1 and EL2 is formed of a conductive metal, such as titanium (Ti), palladium (Pd), tantalum (Ta), gold (Au), copper (Cu), tungsten (W), or aluminum (Al), and may be deposited to measure a current flowing through the ferromagnetic memory device 12 or to supply the current to the ferromagnetic memory device 12. At this time, physical vapor deposition (PVD) or chemical vapor deposition (CVD) can be used as a deposition method.

The first-direction input current Ix_CD1 input to the first current electrode EL1 or the second-direction input current Ix_CD2 input to the second current electrode EL2 may flow through the electric conductive layer 111 to form a current path, as shown in FIG. 3.

FIG. 4 is an enlarged view of the memory cell of the ferromagnetic memory device shown in FIG. 1. Referring to FIGS. 1 through 4, a magnetic anisotropy energy gradient can be formed in the second magnetic layer 30 of the memory cell MC by n (where n is a natural number greater than or equal to 2, and n is assumed to be 3 in the present specification for convenience of description) magnetic domains MD1, MD2, and MD3 with different magnetic anisotropy energies.

As the magnetic domains MD1, MD2, and MD3 are formed, the magnetic free layer 30 has asymmetric magnetic properties.

For convenience of description, this specification uses a case where n is 3 as an example. However, to implement multi-levels or asymmetric magnetic characteristics, one or more magnetic domains may be formed depending on a magnetic anisotropy energy gradient formed in the second magnetic layer 30 or a magnetization state formed by physical defects such as chemical state inhomogeneity and vacancy.

FIG. 5A is an enlarged view of the memory cell shown in FIG. 2 before a formation of a magnetic anisotropy energy gradient in the memory cell shown in FIG. 2, and FIG. 5B is a schematic diagram of the memory cell shown in FIG. 5A, taken in a B-B direction.

FIG. 5A shows a plurality of regions RG1, RG2, and RG3 all together in a plan view of the memory cell MC to describe a stage before the formation of a magnetic anisotropy energy gradient within the memory cell MC.

Here, each of the regions RG1, RG2, and RG3 may refer to a region of the memory cell MC, an internal region within the first magnetic layer 30', or an internal region of a first magnetic layer 30c' matching a surface region of the memory cell MC.

Referring to FIGS. 5A and 5B, the memory cell MC may include a non-magnetic first magnetic material layer 30', for example, a magnetic-free layer including a cobalt oxide (Cₒ₃O₄) layer. As described above, the first magnetic layer 30' may be, but is not limited to, a mixture of paramagnetic and ferromagnetic materials.

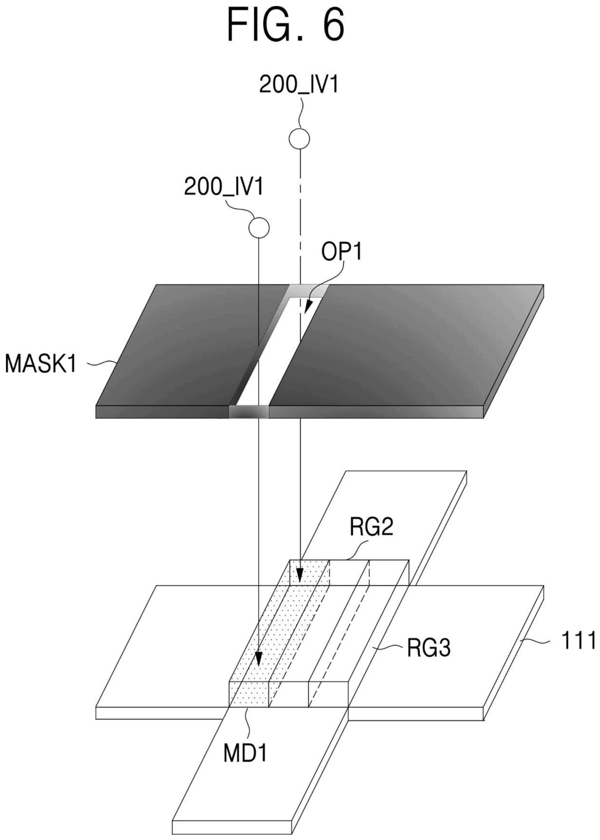

FIG. 6 is a schematic diagram for describing a method of generating a first magnetic domain by irradiating a first region of the memory cell region shown in FIG. 5A with ions accelerated at a first acceleration voltage through a first mask pattern.

Referring to FIGS. 5 and 6, the first region RG1 may be transformed into a first magnetic domain MD1 by irradiating a first region RG1 of the memory cell region MC (or the first magnetic layer 30') with first ions 200_IV1 accelerated at a first acceleration voltage IV1 (e.g., 0.1keV) through a first opening OP1 of the first mask pattern MASK1.

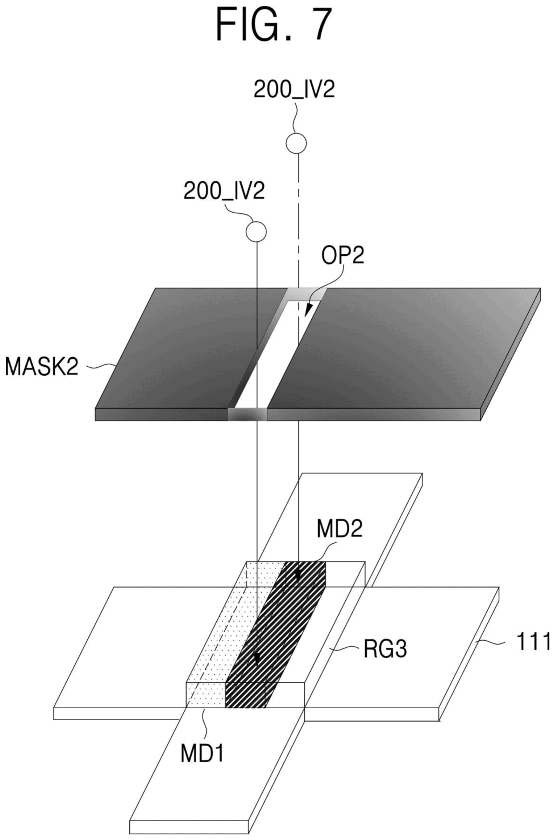

FIG. 7 is a schematic diagram for describing a method for generating a second magnetic domain by irradiating a second region of the memory cell region shown in FIG. 5A with ions accelerated at a second acceleration voltage through a second mask pattern.

Referring to FIGS. 5 and 7, the second region RG2 may be transformed into a second magnetic domain MD2 by irradiating a second region RG2 of the memory cell region MC (or the first magnetic layer 30') with second ions 200_IV2 accelerated at a second acceleration voltage IV2 (e.g., 0.5keV) through a second opening OP2 of the second mask pattern MASK2.

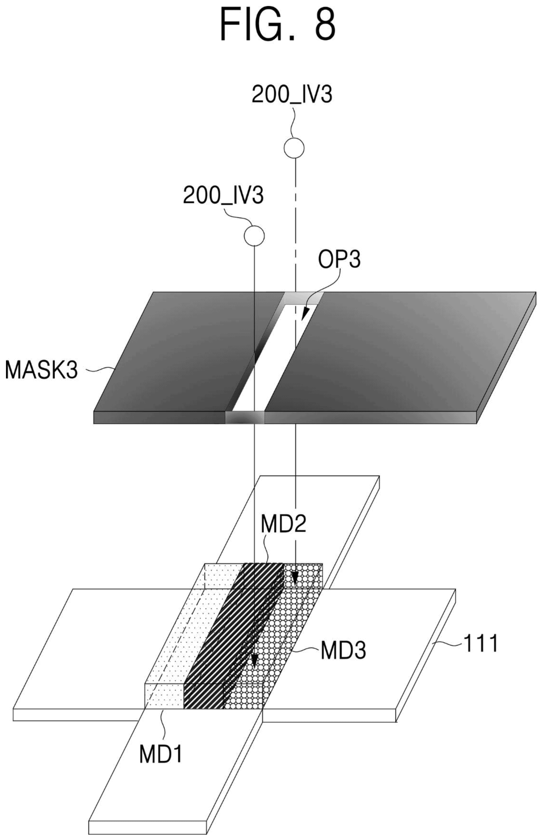

FIG. 8 is a schematic diagram for describing a method for generating a third magnetic domain by irradiating a third region of the memory cell region shown in FIG. 5A with ions accelerated at a third acceleration voltage through a third mask pattern.

Referring to FIGS. 5 and 8, a third region RG3 may be transformed into a third magnetic domain MD3 by irradiating a third region RG3 of the memory cell region MC (or a first magnetic layer 103c') with third ions 200_IV3 accelerated at a third acceleration voltage IV3 (e.g., 0.2keV) through a third opening OP3 of a third mask pattern MASK3.

According to embodiments, the first to third ions 200_IV1, 200_IV2, and 200_IV3 may be ions of the same type (e.g., hydrogen ions) and/or a combination of different types of ions (e.g., a combination of hydrogen ions and helium ions). According to the embodiments, the number of the first ions (200_IV1), the number of the second ions (200_IV2), and the number of the third ions (200_IV3) may be the same or different.

That is, each of the regions RG1, RG2, and RG3 can be changed into each of the magnetic domains MD1, MD2, and MD3 with different magnetic anisotropy energies depending on energies applied to the ions for irradiation (e.g., 0.1keV, 0.5keV, and 0.2keV). According to embodiments, the energy applied to the ions irradiated in the first region RG1 and the third region RG3 may be the same, while the energy applied to the ions irradiated in the second region RG2 may be different, but is not limited to.

By changing an acceleration energy (or acceleration voltage) of the ions with which each region RG1, RG2, or RG3 is irradiated according to a method for ion irradiation, different magnetic properties and/or magnetic anisotropy energies are induced for each magnetic domain MD1, MD2, or MD3 corresponding to each region RG1, RG2, or RG3. Therefore, magnetic anisotropy energy gradient may be formed.

For example, a magnetic anisotropy energy gradient can be induced not only by the magnetization states of the magnetic domains MD1, MD2, and MD3, but also by the magnetization states formed by physical defects such as vacancy and chemical state inhomogeneity formed within the magnetic domains MD1, MD2, and MD3 during ion irradiation.

The chemical state inhomogeneity may arise from a local difference in chemical concentration (or density) or composition within each of the magnetic domains MD1, MD2, and MD3. This inhomogeneity may also arise from an increased accumulation of a compound or a specific substance within each of the magnetic domains MD1, MD2, and MD3 due to ion irradiation, or by defects.

An increase or decrease in concentration of a specific substance within each of the magnetic domains MD1, MD2, and MD3, or a presence of physical defects, may change magnetic properties of a corresponding region.

Moreover, chemical inhomogeneities and physical defects may enhance or weaken anisotropy within each of the magnetic domains MD1, MD2, and MD3, which can cause domain walls of each of the magnetic domains MD1, MD2, and MD3 to move in several stages rather than all at once.

For example, hydrogen ions may collide with a magnetic material contained in each domain RG1, RG2, or RG3, such as oxygen atoms or oxygen ions in cobalt oxide, removing and releasing the oxygen atoms or oxygen ions, thereby reducing the cobalt oxide to metallic cobalt, and transform each region RG1, RG2, or RG3 into each of the magnetic domains MD1, MD2, and MD3. Cobalt oxide may have various compositions in a CoₓO₁₋ₓ form, such as Co₃O₄ or CoO. However, it is reduced to cobalt (Co) upon reduction regardless of composition.

For example, when cobalt oxide (Co₃O₄) is reduced by hydrogen ions (H⁺), it becomes cobalt (Co). During a reduction process, the oxidation state changes, which removes oxygen from the cobalt oxide (Co₃O₄) and forms cobalt. For example, a phase transformation is utilized to reduce the paramagnetic material (or paramagnetic layer) in the first magnetic layer (30') to a ferromagnetic material (or ferromagnetic layer) through an ion irradiation method.

For example, cobalt oxide (Co₃O₄) is a mixed oxide in which cobalt has both 2⁺ and 3⁺ oxidation states. When cobalt oxide (Co₃O₄) is reduced, cobalt changes into a metallic state with an oxidation number of 0.

An example of a reduction reaction of cobalt oxide (Cₒ₃O₄) is shown in Chemical Formula 1.

[Chemical Formula 1] **Co₃G₄ + 8H⁺ + 8e⁻** → **3Co + 4H₂O**

When each region RG1, RG2, or RG3 includes a paramagnetic material (e.g., cobalt oxide (Co₃O₄)), hydrogen ions with which each region RG1, RG2, or RG3 is irradiated (or injected) can reduce the paramagnetic material (e.g., cobalt oxide (Co₃O₄)) included in each region RG1, RG2, or RG3 by a mechanism such as Chemical Formula 1, thereby transforming each region RG1, RG2, or RG3 into each of the magnetic domains MD1, MD2, and MD3, but a transformation method is not limited to Chemical Formula 1.

In another embodiment, when each region RG1, RG2, or RG3 includes both a paramagnetic material (e.g., cobalt oxide (Co₃O₄)) and a ferromagnetic material, hydrogen ions with which each region RG1, RG2, or RG3 is irradiated (or injected) can reduce the paramagnetic material (e.g., cobalt oxide (Co₃O₄)) included in each region RG1, RG2, or RG3 by a mechanism such as Chemical Formula 1, thereby transforming each region RG1, RG2, or RG3 into each of the magnetic domains MD1, MD2, and MD3, but the transformation method is not limited to Chemical Formula 1. For example, the paramagnetic oxide (Cₒ₃O₄) is transformed into the metallic ferromagnet (Co) through irradiation with accelerated hydrogen ions.

The oxide paramagnetic material (Cₒ₃O₄) undergoes a phase transformation into metallic ferromagnetic cobalt (Co) when irradiated with accelerated hydrogen ions. By varying the acceleration energy of the ions during ion irradiation, a greater amount of the oxide paramagnetic material (Cₒ₃O₄) transforms into metallic ferromagnetic cobalt (Co).

Since the interactions between the reduced metallic ferromagnetic cobalt (Co) atoms differ, the magnetic anisotropy energy varies according to each acceleration energy. In other words, depending on the energy of the hydrogen ions irradiated (or implanted) in each region RG1, RG2, or RG3, the atoms of the reduced metallic ferromagnetic cobalt (Co) can initially exist as individual atoms during the initial transformation process into each magnetic domain MD1, MD2, and MD3.

As the reduction continues, the interactions between the reduced metallic ferromagnetic cobalt (Co) atoms cause the atoms to cluster together to form nuclei, and as the reduction proceeds further, a continuum of nuclei can be formed. At each stage of nucleus, nuclei, or continuum formation, the interactions between the reduced metallic ferromagnetic cobalt (Co) atoms change, and the spin-orbit interactions also vary at each stage.

Consequently, the magnetic anisotropy energy ultimately changes. That is, depending on the reduction state and the clustered state of the reduced metallic ferromagnetic cobalt (Co) atoms, the magnetic anisotropy energy varies, thereby forming a magnetic anisotropy energy gradient.

A continuum containing the reduced metallic ferromagnetic cobalt (Co) atoms exists within each magnetic domain MD1, MD2, and MD3 reduced by different acceleration energies. The spin-orbit coupling differs between each magnetic domain MD1, MD2, and MD3, resulting in the formation of a magnetic anisotropy energy gradient.

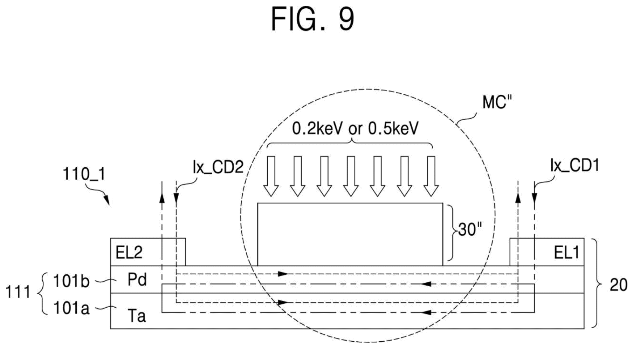

FIG. 9 is a schematic diagram for describing a method of irradiating a magnetic free layer of a memory cell with ions at 0.2keV or 0.5keV so that the memory cell has uniform magnetic properties.

Referring to FIG. 9, a memory cell MC" has uniform magnetic properties by irradiating a magnetic free layer 30" of a memory cell region MC" with second ions 200_IV2 accelerated at a single ion irradiation energy, for example, the second acceleration voltage IV2 (e.g., 0.5keV).

It is assumed that a ferromagnetic memory device including the memory cell MC" or the magnetic free layer 30" shown in FIG. 9 includes the composite layer 20 having the SHE layer and the second terminal, the tunnel barrier 40, the magnetic reference layer 50, and the first terminal 60.

As another example, the memory cell MC" has uniform magnetic properties by irradiating a magnetic free layer 30" of the memory cell MC" with third ions 200_IV2 accelerated at a single ion irradiation energy, for example, the third acceleration voltage IV3 (e.g., 0.2keV).

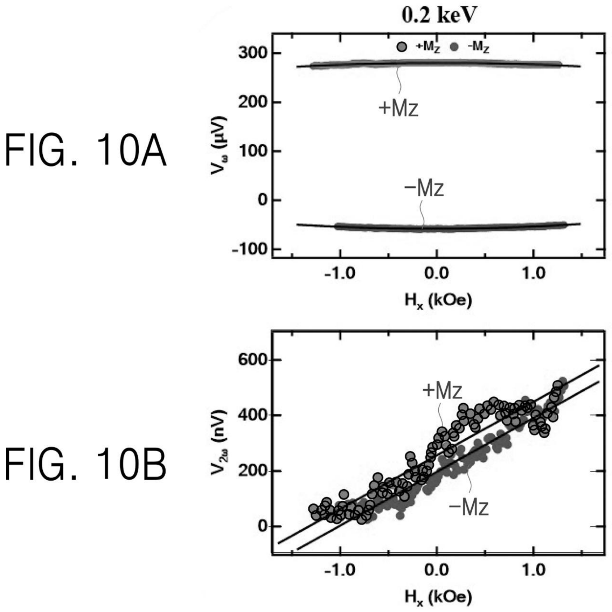

FIG. 10A is a graph which shows a relationship among a first harmonic voltage V_{ω} measured in a ferromagnetic memory device including a memory cell MC", an in-plane magnetic field Hₓ, and magnetization directions +Mz and -Mz when a magnetic free layer 30" of the memory cell MC" is irradiated with ions at 0.2keV as shown in FIG. 9 , and FIG. 10B is a graph which shows a relationship among a second harmonic voltage V_{2ω} measured in a ferromagnetic memory device including a memory cell MC", an in-plane magnetic field Hₓ, and magnetization directions +Mz and -Mz when a magnetic free layer 30" of the memory cell MC" is irradiated with ions at 0.2keV as shown in FIG. 9.

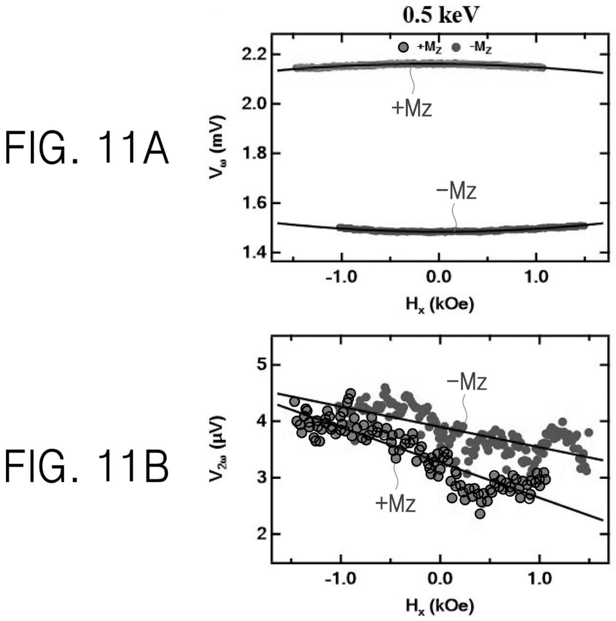

In FIGS. 10A, 10B, 11A, and 11B, when a charge current is in an x-axis direction, a spin current is in a z-axis direction, and a magnetic field (or external magnetic field) is in the x-axis direction, +Mz indicates that a magnetization direction of the magnetic free layer 30 is a +z direction, and -Mz indicates that the magnetization direction of the magnetic free layer 30 is a -z direction.

In FIG. 10A, the x axis represents the in-plane magnetic field Hₓ, and the y axis represents the first harmonic voltage V_{ω} when the current Ix_CD1 or Ix_CD2 and the magnetic field are parallel. In FIG. 10B, the x axis represents the in-plane magnetic field Hₓ, and the y axis represents the second harmonic voltage V_{2ω} when the current Ix_CD1 or Ix_CD2 and the magnetic field are parallel.

At this time, a spin Hall angle (θ_{SH}) of the ferromagnetic memory device including a memory cell MC" having uniform magnetic properties, that is, a memory cell MC" in which magnetic domains are not formed, by ion irradiation with a single ion irradiation energy, for example, 0.2keV, may be calculated according to Equation 1. [Equation 1] ${θ}_{SH} = \frac{2 {eM}_{s} {t}_{F}}{ℏ Jac} Δ {H}_{DL}$

Here, e is a magnitude of an electron charge, Mₛ is saturation magnetization of the magnetic free layer 30", t_{F} is a thickness of the magnetic free layer 30", h is a Effective Planck constant, Jac is a current density supplied to the SHE layer 111, and ΔH_{DL} is damping-like torque. For example, the current density Jac is a current flowing per cross-sectional area.

However, the spin Hall angle θ_{SH} in Equation 1 is not calculated only by the damping-like torque ΔH_{DL}. In this embodiment, a field-like torque, one of important spin torques, is relatively small compared to the damping-like torque ΔH_{DL}. Therefore, the spin Hall angle θ_{SH} can be approximated and expressed only by the damping-like torque ΔH_{DL}, as in Equation 1. Therefore, the spin Hall angle θ_{SH} is not limited to Equation 1.

When the magnetic free layer 30" is irradiated with ions at 0.2keV, if e is 1.6×10⁻¹⁹C, Mₛ is 744.1 emu/cm³, t_{F} is 7×10⁻⁸cm, ΔH_{DL} is 89.5 Oe (Oersted), h is 1.05×10⁻²⁷erg·s, and Jac is 6.8×10⁶A/cm², the spin Hall angle θ_{SH} is calculated to be 0.198 according to Equation 1.

In a case of a ferromagnetic memory device including a memory cell MC" manufactured by ion irradiation with a single ion irradiation energy, for example, 0.2keV, that is, a memory cell MC" in which magnetic domains are not formed, the measured damping-like torque ΔH_{DL} is small, and the spin Hall angle θ_{SH} is also small. Therefore, even if the current Ix_CD1 or Ix_CD2 supplied to the SHE layer 111 of the ferromagnetic memory device is significantly increased, spin torque switching does not occur in an MTJ included in the memory cell MC" of the ferromagnetic memory device.

In addition, in the case of a magnetic free layer 30 without asymmetry such as a magnetic anisotropy energy gradient or intrinsic structural non-uniformity, or in a ferromagnetic memory device without a structure that breaks symmetry, switching by spin torque alone is difficult. In such cases, switching may be achieved by applying an external magnetic field to break the symmetry.

That is, the ferromagnetic memory device including the memory cell MC" manufactured by ion irradiation with a single ion irradiation energy, for example, 0.2keV, cannot perform spin torque switching in the absence of an external magnetic field, even if the strong current Ix_CD1 or Ix_CD2 is supplied to the SHE layer 111, because there is no structure to break the symmetry.

FIG. 11A is a graph which shows a relationship among a first harmonic voltage Vω measured in a ferromagnetic memory device including a memory cell MC", that is, a memory cell MC" in which magnetic domains are not formed, an in-plane magnetic field Hₓ, and magnetization directions +Mz and -Mz when a magnetic free layer 30" of the memory cell MC" is irradiated with ions at 0.5keV, as shown in FIG. 9. FIG. 11B is a graph which shows a relationship among a second harmonic voltage V_{2ω} measured in a ferromagnetic memory device including a memory cell MC", that is, a memory cell MC" in which magnetic domains are not formed, an in-plane magnetic field Hₓ, and magnetization directions +Mz and -Mz, when a magnetic free layer 30" of the memory cell MC" is irradiated with ions at 0.5keV, as shown in FIG. 9.

In FIG. 11A, the x axis represents the planar magnetic field Hₓ and the y axis represents the first harmonic voltage Vω when the current Ix_CD1 or Ix_CD2 and the magnetic field are parallel. In FIG. 11B, the x axis represents the planar magnetic field Hₓ and the y axis represents the second harmonic voltage V_{2ω} when the current Ix_CD1 or Ix_CD2 and the magnetic field are parallel.

When the magnetic free layer 30" is irradiated with a single ion irradiation energy, for example, 0.5keV, if e is 1.6× 10⁻¹⁹C, Mₛ is 989.5 emu/cm³, t_{F} is 7×10⁻⁸ cm, ΔH_{DL} is 28.3 Oe, h is 1.05×10⁻²⁷ erg·s, and Jac is 6.8×10⁶A/cm², the spin Hall angle Θ_{SH} is calculated to be 0.067 according to Equation 1.

In a case of the ferromagnetic memory device including the memory cell MC" manufactured by ion irradiation with a single ion irradiation energy, for example, 0.2keV, not only is the measured damping-like torque ΔH_{DL} very small, but the spin Hall angle θ_{SH} is also very small, so that, even if the current Ix_CD1 or Ix_CD2 supplied to the SHE layer 111 of the ferromagnetic memory device is significantly increased, spin torque switching does not occur in the MTJ included in the memory cell MC" of the ferromagnetic memory device.

In addition, in the case of a magnetic free layer 30 without asymmetry such as a magnetic anisotropy energy gradient or intrinsic structural non-uniformity, or in a ferromagnetic memory device without a structure that breaks symmetry, switching by spin torque alone is difficult. In such cases, switching can be achieved by applying an external magnetic field to break the symmetry.

That is, the ferromagnetic memory device including the memory cell MC" manufactured by ion irradiation with a single ion irradiation energy, for example, 0.5keV, cannot perform spin torque switching in the absence of an external magnetic field, even if the strong current Ix_CD1 or Ix_CD2 is supplied to the SHE layer 111, because there is no structure to break the symmetry.

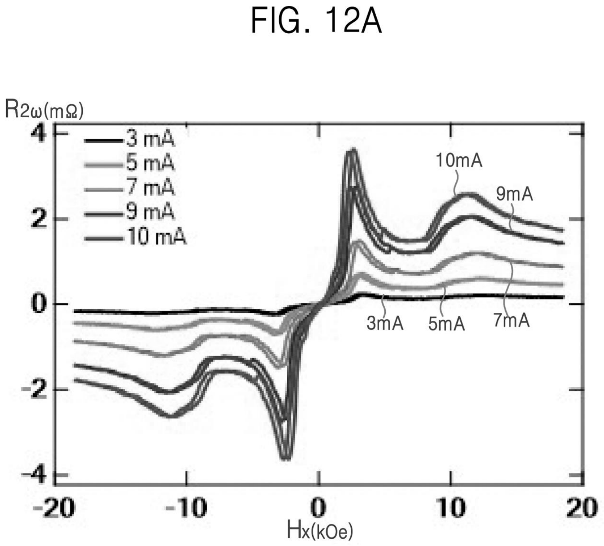

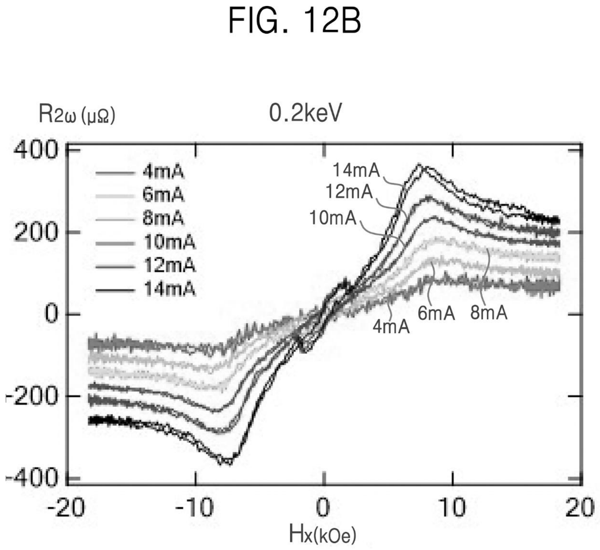

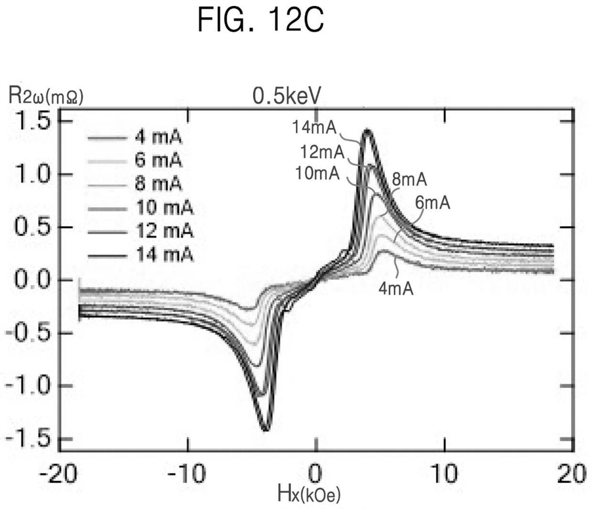

FIG. 12A is a graph which shows a relationship among a value R_{2ω} obtained by transforming a second harmonic voltage measured in a ferromagnetic memory device 12 which includes a memory cell MC having a magnetic free layer 30 with the magnetic domains MD1, MD2, and MD3 formed thereon according to different acceleration energies (e.g., acceleration energies sequentially applied in order of 0.1keV, 0.5keV, and 0.2keV) into second harmonic resistance, an in-plane magnetic field Hx, and a current. FIG. 12B is a graph which shows a relationship among a value R_{2ω} obtained by transforming a second harmonic voltage measured in a ferromagnetic memory device which includes a memory cell MC" into second harmonic resistance, an in-plane magnetic field Hₓ, and a current when a magnetic free layer 30" of the memory cell MC" is irradiated with ions at 0.2keV as shown in FIG. 9, and FIG. 12C is a graph which shows a relationship among a value R_{2ω} obtained by transforming a second harmonic voltage measured in a ferromagnetic memory device which includes a memory cell MC" into second harmonic resistance, an in-plane magnetic field Hₓ, and a current when a magnetic free layer 30" of the memory cell MC" is irradiated with ions at 0.5keV as shown in FIG. 9.

In FIGS. 12A, 12B, and 12C, the transformed second harmonic resistance value R_{2ω} is a second harmonic resistance value when a current direction and a magnetic field direction are the same.

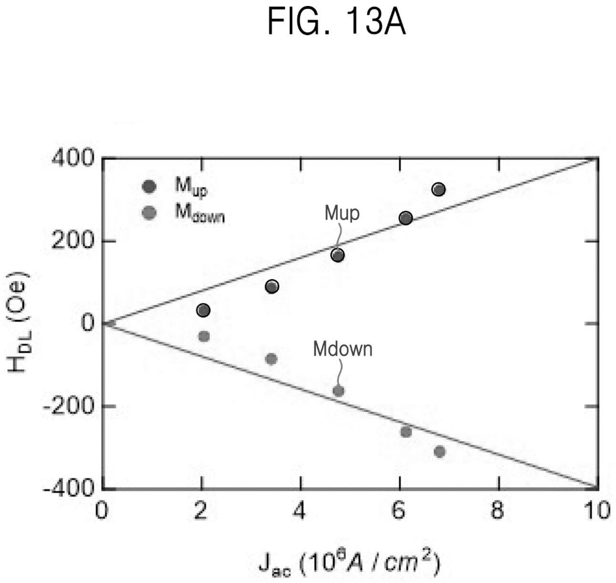

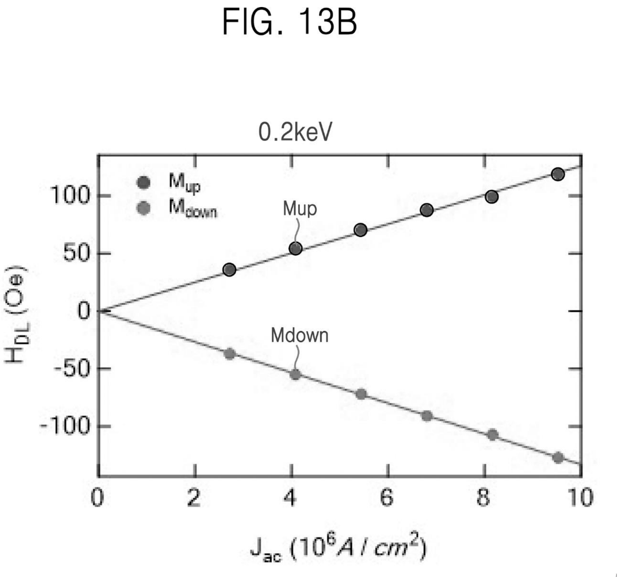

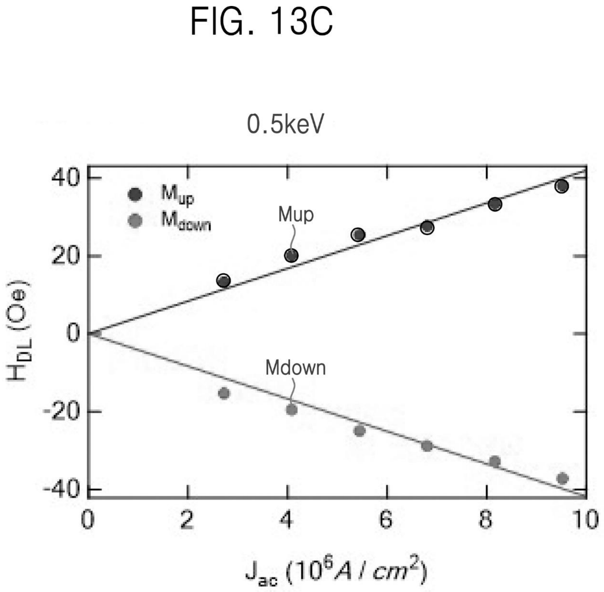

FIG. 13A is a graph which shows a relationship among a current density Jac supplied to the ferromagnetic memory device 12 which includes the memory cell MC having a magnetic free layer 30 with the magnetic domains MD1, MD2, and MD3 formed thereon according to different acceleration energies (e.g., acceleration energies sequentially applied in order of 0.1keV, 0.5keV, and 0.2keV), damping-like torque H_{DL}, and magnetization directions Mᵤₚ (or +M_{z}) and M_{down} (or -M_{z}), according to an embodiment of the present invention. FIG. 13B is a graph which shows a relationship among a current density Jac supplied to a ferromagnetic memory device including a memory cell MC', damping-like torque H_{DL}, and magnetization directions Mᵤₚ and M_{down} when a magnetic free layer 30" of the memory cell MC" is irradiated with ions at 0.2keV as shown in FIG. 9, and FIG. 13C is a graph which shows a relationship among a current density Jac supplied to a ferromagnetic memory device including a memory cell MC", damping-like torque H_{DL}, and magnetization directions Mup and Mdown when a magnetic free layer 30" of the memory cell MC" is irradiated with ions at 0.5keV as shown in FIG. 9.

Referring to FIG. 12A, the value R_{2ω} obtained by transforming a second harmonic voltage measured in the ferromagnetic memory device 12 which includes a memory cell MC having a magnetic free layer 30 into second harmonic resistance changes depending on a magnitude (e.g., 3 mA, 5 mA, 7 mA, 9 mA, and 10 mA) of the current Ix_CD1 or Ix_CD2 supplied to the SHE layer 111 of the memory cell MC.

Referring to FIG. 12B, the value R_{2ω} obtained by transforming a second harmonic voltage measured in the ferromagnetic memory device which includes a memory cell MC" having a magnetic free layer 30" into second harmonic resistance changes depending on a magnitude (e.g., 4 mA, 6 mA, 8 mA, 10 mA, 12 mA, and 14 mA) of the current Ix_CD1 or Ix_CD2 supplied to the SHE layer 111 of the memory cell MC".

Referring to FIG. 12C, the value R_{2ω} obtained by transforming a second harmonic voltage measured in the ferromagnetic memory device which includes a memory cell MC" having a magnetic free layer 30" into second harmonic resistance changes depending on the magnitude (e.g., 4 mA, 6 mA, 8 mA, 10 mA, 12 mA, and 14 mA) of the current Ix_CD1 or Ix_CD2 supplied to the SHE layer 111 of the memory cell MC".

Referring to FIGS. 12A, 12B, and 12C, a second harmonic resistance value R_{2ω} during ion irradiation with 0.5keV is greater than a second harmonic resistance value R_{2ω} during ion irradiation with 0.2keV, and a second harmonic resistance value R_{2ω} of the ferromagnetic memory device 12 according to the embodiment of the present invention is greater than a second harmonic resistance value R_{2ω} during ion irradiation with 0.5keV.

Referring to FIGS. 13A, 13B, and 13C, it can be confirmed that as the current density Jac supplied to the SHE layer 111 increases, a magnitude of the damping-like torque H_{DL} acting when the magnetization is in an upward direction Mᵤₚ (a magnetization vector is +M_{z}) state and in a downward direction M_{down} (a magnetization vector is -M_{z}) state both increases.

When the first magnetic domain MD1 formed in the magnetic free layer 30 is irradiated with ions at 0.1keV, the second magnetic domain MD2 is irradiated with ions at 0.5keV, and the third magnetic domain MD3 is irradiated with ions at 0.2keV, if e is 1.6×10⁻¹⁹C, Mₛ is 703.6 emu/cm³, t_{F} is 7×10⁻⁸cm, ΔH_{DL} is 316.3 Oe, h is 1.05×10⁻²⁷erg·s, and Jac is 6.8×10⁶A/cm², the spin Hall angle θ_{SH} is calculated to be 0.698 according to Equation 1.

The damping-like torque ΔH_{DL} is a key factor in reversing the magnetization direction of the magnetic free layer 30.

That is, when the current density Jac is 6.8×10⁶A/cm², the spin Hall angle (θ_{SH}=0.695) when the magnetic domains MD1, MD2, and MD3 are formed on the magnetic free layer 30 increases by about 3.5 times compared to the spin Hall angle (θ_{SH}=0.198) when the magnetic free layer 30" is irradiated with ions at 0.2keV, as shown in FIG. 9, and increases by about 10.4 times compared to the spin Hall angle (θ_{SH}=0.067) when the magnetic free layer 30" is irradiated with ions at 0.5keV, as shown in FIG. 9.

In addition, ΔH_{DL} (= 316.3 Oe) when the magnetic domains MD1, MD2, and MD3 are formed on the magnetic free layer 30 increases significantly compared to ΔH_{DL} (= 89.5 Oe) when the magnetic free layer 30" is irradiated with ions at 0.2keV and ΔH_{DL} (= 28.3 Oe) when the magnetic free layer 30" is irradiated with ions at 0.5keV.

As the spin Hall angle θ_{SH} increases, spin torque efficiency increases. Spin torque efficiency is a measure of how efficiently charge current can be converted into spin torque. Under conditions where a charge current or current density is the same, an increase in spin Hall angle θ_{SH} increases a spin current, and the magnitude of the spin torque originating from the spin current also increases. In other words, the increase in spin Hall angle θ_{SH} increases charge-to-spin transformation efficiency, thereby increasing spin torque and facilitating magnetization reversal or spin torque switching.

According to the present invention, the total spin torque applied to a spintronic device 12, for example, a magnetic free layer 30, including magnetic domains MD1, MD2, and MD3 formed to have a magnetic anisotropy energy gradient, is greater than the total spin torque applied to a spintronic device (e.g., a magnetic free layer) without a magnetic anisotropy energy gradient, regardless of the type of torque (e.g., damping-like torque, field-like torque, or orbital torque).

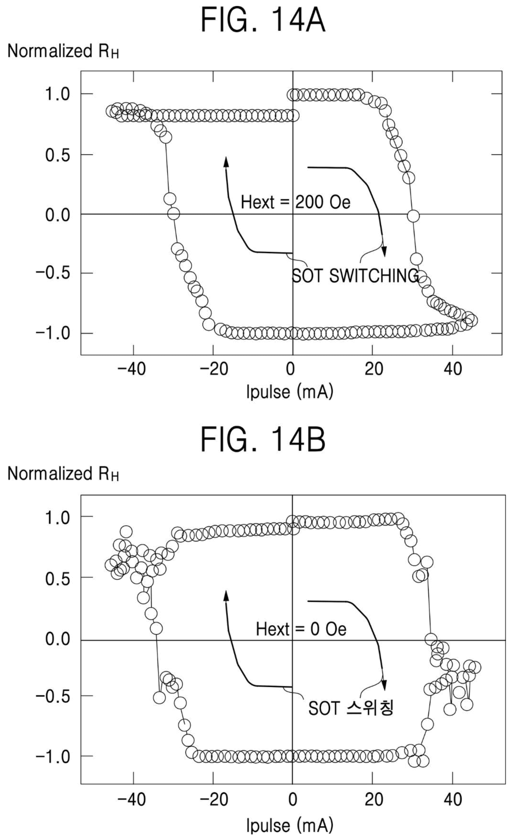

FIG. 14A is a graph which shows a relationship between a charge current and spin torque switching in a memory cell having a magnetic free layer with magnetic domains formed thereon according to an embodiment of the present invention when an external magnetic field is present. FIG. 14B is a graph which shows a relationship between a charge current and spin torque switching in a memory cell having a magnetic free layer with magnetic domains formed thereon according to an embodiment of the present invention when an external magnetic field is not present.

In FIGS. 14A and 14B, the x axis represents a charge current Ipulse, and the y axis represents normalized Hall resistance R_{H}.

Referring to FIGS. 1, 2, 14A, and 14B, a magnetic state of a memory cell MC in which the magnetic domains MD1, MD2, and MD3 are formed according to the present invention already has an asymmetric state. Therefore, even when an external magnetic field Hext (e.g., 200 Oe) is applied to the ferromagnetic memory device 12 including the memory cell MC (FIG. 14A) or no external magnetic field Hext (e.g., 0 Oe) is applied thereto (FIG. 14B), spin torque switching is possible by spin torque generated according to a pulse current (Ix_CD1=Ipulse or Ix_CD2=Ipulse) supplied to the SHE layer 111.

Accordingly, a ferromagnetic memory device 12 in which the magnetic domains MD1, MD2, and MD3 are formed according to the present invention can be referred to as a field-free spin torque switching device.

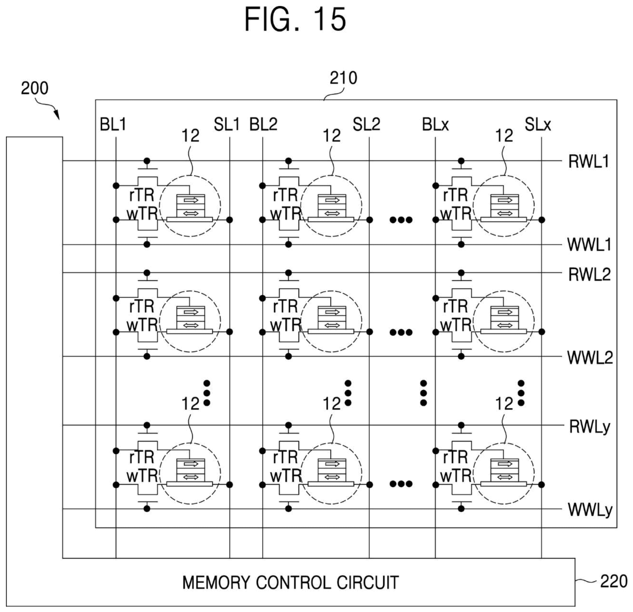

FIG. 15 is a block diagram of a memory device including the ferromagnetic memory device shown in FIG. 1. Referring to FIGS. 1 and 15, a memory device (or electronic device) 200 includes a memory cell array 210 including memory cells 12 for storing data in a non-volatile manner, and a memory control circuit 220 connected to the memory cell array 210 and controlling data read or write operations for each of the memory cells 12.

Here, each of the memory cells 12 refers to the ferromagnetic memory device 12 in which the magnetic domains MD1, MD2, and MD3 shown in FIG. 1 are formed. In the memory device 200, the ferromagnetic memory device 12 functions as a unit cell.

Each memory cell 12 is connected to each bit lines BL1 to BLx (where x is a natural number greater than or equal to 3), each read word lines RWL1 to RWLy (where y is a natural number greater than or equal to 3), each write word lines WWL1 to WWLy, and each source lines SL1 to SLx.

Each read access transistor rTR is connected between each bit line BL1 to BLx and the first terminal 60 of each memory cell 12, and a gate of each read access transistor rTR is connected to each read word line RWL1 to RWLy.

Each write access transistor wTR is connected to each bit line BL1 to BLy and a first current electrode EL1 of each memory cell 12, and a gate of each write access transistor wTR is connected to each write word line WWL1 to WWLy. A second current electrode EL2 of each memory cell 12 is connected to each source line SL1 to SLy.

The memory control circuit 220 performs a decoding operation for selecting a write word line (at least one of WWL1 to WWLy) to select a memory cell 12 which is subject to a write operation, and a function for driving a signal to turn on a write access transistor wTR connected to the selected memory cell.

The memory control circuit 220 performs a decoding operation for selecting a read word line (at least one of RWL1 to RWLy) to select a memory cell 12 which is subject to a read operation, and a function for driving a signal to turn on a read access transistor rTR connected to the selected memory cell.

The memory control circuit 220 performs a decoding operation for selecting a bit line (at least one of BL1 to BLx) to select a memory cell 12 which is subject to a write operation, and a function for supplying a write current pulse to the selected bit line.

In addition, the memory control circuit 220 performs a decoding operation for selecting a bit line (at least one of BL1 to BLx) to select a memory cell 12 which is subject to a read operation, and a function for detecting a voltage or current output from the selected bit line and generating a detection signal.

Selecting one of the memory cells 12 for a write operation means, according to the decoding operation of the memory control circuit 220, forming a write current path between a bit line connected to the first current electrode EL1 of the selected memory cell and a source line connected to the second current electrode EL2 of the selected memory cell, and using a write current flowing through the write current path to change a magnetization state (or magnetization direction) of the selected memory cell.

In addition, selecting one of the memory cells 12 for a read operation means, according to the decoding operation of the memory control circuit 220, forming a read current path between a bit line connected to the first terminal 60 of the selected memory cell and a source line connected to the second current electrode EL2 of the selected memory cell, and causing a read current to flow toward the source line through the read current path.

For example, a write current Iwrt for writing a logic '1' (or data '1') can flow horizontally from a bit line to a source line through the composite layer 20 using a turned-on write access transistor wTR to induce magnetization reversal in the magnetic free layer 30. Furthermore, a write current Iwrt for writing a logic '0' (or data '0') can flow horizontally from a source line to a bit line through the composite layer 20 using the turned-on write access transistor wTR to induce the magnetization reversal in the magnetic free layer 30.

If an external magnetic field is applied to the memory device 200, spin torque switching can occur simultaneously in all memory cells 12, making it impossible to control spin torque switching for each memory cell 12.

However, since each memory cell 12 of the memory device 200 according to an embodiment of the present invention is capable of performing spin torque switching even at a low charge current Ix_CD1 or Ix_CD2 supplied to each memory cell 12 without an aid of an external magnetic field, spin torque switching is possible for each memory cell 12.

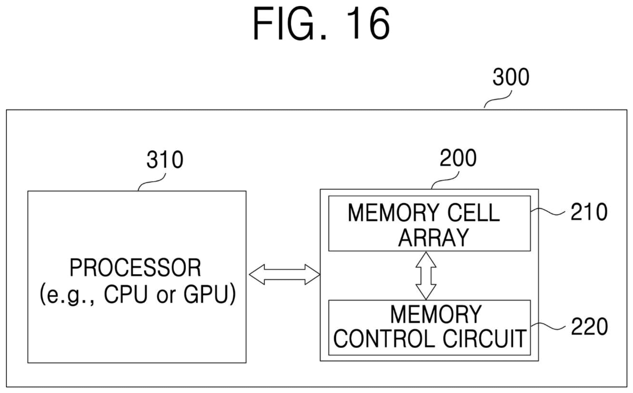

FIG. 16 is a block diagram of a memory system including the memory device shown in FIG. 15. Referring to FIGS. 1, 15, and 16, a memory system (or electronic device), for example, a processor-in-memory 300 or an in-memory computing system 300, includes a processor 310 and a memory device 200. The processor 310 may be a central processing unit (CPU), a graphics processing unit (GPU), or a neural processing unit (NPU), and the memory device 200 includes a memory cell array 210 capable of not only storing data but also directly performing logical operations, and the memory control circuit 220 capable of performing write and read operations on the memory cell array 210.

The process-in-memory 300 or in-memory computing system 300 can be used in autonomous vehicles, the Internet of Things (IoT), health informatics, or system on chip (SoC).

The ferromagnetic memory device 12 can be used in a domain wall-based magnetic memory.

The memory cell array 210 includes a memory cell MC or ferromagnetic memory device 12 including the magnetic free layer 30 that includes domains formed by ion irradiation with different energies, for example, a first magnetic domain MD1 formed by ion irradiation with an energy of 0.1keV, a second magnetic domain MD2 formed by ion irradiation with an energy of 0.5keV, and a third magnetic domain MD3 formed by ion irradiation with an energy of 0.2keV, and the memory control circuit 220 can perform an operation corresponding to a command output from the processor 310 within the memory cell array 210 and transmit data corresponding to a result of the performance, for example, only the result, to the processor 310. Accordingly, an operational capability of the process-in-memory 300 or the in-memory computing system 300 can be improved and power consumption can be reduced.

The ferromagnetic memory device 12 capable of defining or storing any one of the multi-levels according to the present invention, unlike a conventional STT-MRAM capable of defining or storing only single-bit data, can be used in the process-in-memory 300 or in-memory computing system 300 for artificial intelligence (AI) or intelligent semiconductors for deep learning, and the like.

If a time-sequential input pulse sequence including a series of pulses is input to one input terminal, for example, the first current electrode EL1, of the ferromagnetic memory device 12, the ferromagnetic memory device 12 can align magnetization directions of all magnetic domains MD1 to MD3 downward in response to a first pulse included in the series of pulses, invert only a magnetization direction of the first magnetic domain MD 1 among the magnetic domains MD 1 to MD3 upward in response to a second pulse included in the series of pulses, and invert only a magnetization direction of the second magnetic domain MD2 among the magnetic domains MD 1 to MD3 upward in response to a third pulse included in the series of pulses.

According to an embodiment of the present invention, a spintronic device including magnetic domains formed to have a magnetic anisotropy energy gradient may perform switching a unit cell of the ferromagnetic memory device by spin torque even at a low charge current without the aid of an external magnetic field.

According to an embodiment of the present invention, the magnitude of the spin torque of the spintronic device, which includes magnetic domains formed to have a magnetic anisotropy energy gradient, was calculated using the damping-like torque, which shows a relatively large value. While only the damping-like torque was used to calculate the spin Hall angle, other torques, such as the field-like torque, may also be considered.

According to an embodiment of the present invention, in the case of a spintronics device including magnetic domains formed to have a magnetic anisotropy energy gradient, magnetization switching occurred under the application of charge current in the absence of an external magnetic field, whereas no switching occurred in a spintronics device without a magnetic anisotropy energy gradient.

This fact indicates that, without calculating the spin Hall angle based on any equations, the spin Hall angle of a spintronics device containing magnetic domains formed to have a magnetic anisotropy energy gradient is greater than the spin Hall angle of a spintronics device without a magnetic anisotropy energy gradient. For example, a total spin torque applied to the magnetic free layer is greater than a total spin torque applied to a magnetic free layer including magnetic domains in which no magnetic anisotropy energy gradient is formed.

In other words, the total spin torque applied to a spintronics device containing magnetic domains formed to have a magnetic anisotropy energy gradient (e.g., magnetic free layer), regardless of whether it is damping-like torque, field-like torque, orbital torque, or any other related torques, has a greater effect than the total spin torque applied to a spintronics device without a magnetic anisotropy energy gradient (e.g., magnetic free layer).

According to an embodiment of the present invention, a spin Hall angle or damping-like torque of a spintronic device including magnetic domains formed to have a magnetic anisotropy energy gradient is significantly increased compared to a spin Hall angle or damping-like torque of a spintronic device not including the magnetic domains. Therefore, the spintronic device including the magnetic domains enables spin torque switching even at a very low charge current without the aid of an external magnetic field, thereby enabling low-power, high-speed operation.

By patterning a unit cell of a ferromagnetic memory device using a ferromagnetic material into a plurality of regions with different magnetic anisotropy energies, a combination of magnetic domains can be formed, thereby significantly increasing the spin torque.

Although a few embodiments of the present general inventive concept have been shown and described, it will be appreciated by those skilled in the art that changes may be made in these embodiments without departing from the principles and spirit of the general inventive concept, the scope of which is defined in the appended claims and their equivalents.

## Claims

1. A spintronic device comprising a memory device, the memory device comprising a magnetic free layer and a spin Hall effect layer formed below or above the magnetic free layer and configured to generate a spin current from a charge current by a spin Hall effect and to generate a spin torque in the magnetic free layer based on the spin current, **characterised in that** the magnetic free layer includes magnetic domains formed to have a magnetic anisotropy energy gradient, wherein a magnetisation direction of the magnetic free layer is switched by the spin torque even in the absence of an external magnetic field applied to the spintronic device.

2. The spintronic device according to claim 1, **characterised in that** the magnetic domains are formed by irradiating the magnetic free layer with one or more types of ions, each type being accelerated at one or more energy levels or combinations thereof.

3. The spintronic device according to claim 1 or 2, **characterised in that** a total spin torque applied to the magnetic free layer is greater than a total spin torque applied to a magnetic free layer including magnetic domains in which no magnetic anisotropy energy gradient is formed.

4. The spintronic device according to any one of claims 1 to 3, **characterised in that** the magnetic domains comprise a first magnetic domain formed by irradiation with ions accelerated at a first energy, a third magnetic domain formed by irradiation with ions accelerated at a third energy, and a second magnetic domain positioned between the first magnetic domain and the third magnetic domain and formed by irradiation with ions accelerated at a second energy.

5. The spintronic device according to any one of claims 1 to 4, **characterised in that** the spintronic device further comprises a memory cell array including memory cells for storing data, the memory cell array being comprised in the memory device, and a memory control circuit connected to the memory cell array and configured to read or write data from or to the memory cells.

6. The spintronic device according to claim 5, **characterised in that** each of the memory cells includes the magnetic free layer and the spin Hall effect layer as defined in claim 1, wherein the magnetisation direction of the magnetic free layer is switched by the spin torque even in the absence of an external magnetic field applied to the memory device.

7. The spintronic device according to claim 5 or 6, **characterised in that** the spintronic device further comprises a processor configured to control an operation of the memory device.

8. The spintronic device according to claim 7, **characterised in that** the processor is configured to read or write data from or to the memory cells of the memory device through the memory control circuit.

9. The spintronic device according to any one of claims 1 to 8, **characterised in that** the magnetic domains are as defined in claim 4 and are configured such that the magnetic anisotropy energy gradient enhances the switching efficiency of the magnetic free layer.
